# FASCICULE DE BREVET EUROPEEN

(11) **EP 0 520 563 B1**
(45) Date de publication et mention de la délivrance du brevet: **11.12.1996**
(21) Numéro de dépôt: 92201811.4
(22) Date de dépôt: 19.06.1992
(51) Int. Cl.: G01S 7/52, G01R 25/08

(54) **Echographie ultrasonore à correction adaptative d'aberration de phase**
Ultraschall-Echographie mit adaptiver Phasenaberrationkorrektur
Ultrasonic echography with phase aberration adaptive correction

(30) Priorité: 28.06.1991 FR 9108061
(43) Date de publication de la demande: 30.12.1992
(73) Titulaire: LABORATOIRES D'ELECTRONIQUE PHILIPS S.A.S., 94450 Limeil-Brévannes (FR); Philips Electronics N.V., 5621 BA Eindhoven (NL)
(72) Inventeur: Mallart, Raoul, Société Civile S.P.I.D., F-75008 Paris (FR)
(74) Mandataire: Landousy, Christian

(56) Documents cités:
- EP-A- 0 121 732
- EP-A- 0 256 481
- EP-A- 0 320 303
- EP-A- 0 459 583
- ELEKTROTECHNISCHE ZEITSCHRIFT, AUSGABE B. vol. 25, no. 11, 5 Juin 1973, BERLIN DE pages 267-270 A. HAUG ' Digitale Methoden der Phasenmessung'

## Description

La présente invention concerne un appareil d'examen de milieux par échographie ultrasonore, comprenant un réseau de m éléments transducteurs ultrasonores associé à un étage d'émission de signaux ultrasonores vers le milieu à explorer et à un étage de réception et traitement des signaux échographiques renvoyés par le milieu exploré vers lesdits éléments transducteurs, lesdits étages d'émission et de réception et traitement comprenant respectivement des moyens de focalisation par application de retards appropriés dans les n voies d'émission et dans les n voies de réception qui sont associées, parmi lesdits m éléments, aux n éléments transducteurs constituant l'ouverture ultrasonore, l'étage de réception et traitement comprenant en outre :
(a) des moyens de détermination de (n-1) valeurs de correction des retards de focalisation, associés auxdites n voies de réception ;
(b) des moyens de correction, en fonction des (n-1) valeurs ainsi déterminées, des retards de focalisaton à l'émission et/ou à la réception.

Le principe de fonctionnement des échographes actuels repose en général sur l'hypothèse d'une vitesse ultrasonore constante dans les tissus explorés, notamment pour permettre le calcul des différents retards de focalisation et de l'angulation éventuelle des faisceaux pour permettre la conversion des informations liées aux temps de vol des échos en informations de profondeur. Cependant, cette hypothèse est rarement vérifiée la vitesse de propagation des ultrasons a par exemple pour valeur moyenne dans le foie 1540 m/s, tandis que, dans les tissus lipidiques, elle vaut approximativement 1300 m/s. Il en résulte, aussi bien en émission qu'en réception, essentiellement un effet de défocalisation des faisceaux ultrasonores, qui entraîne une perte de résolution et de contraste des images d'autant plus importante que l'on utilise de plus grandes ouvertures focalisantes et des sondes de fréquence plus élevée. L'influence de la fréquence sur la dégradation ainsi constatée peut être comprise en rappelant la nécessité de conserver une précision sur les retards d'un huitième de longueur d'onde environ, ce qui correspond à une précision d'autant meilleure que la fréquence est plus élevée, tandis que l'influence de la taille de l'ouverture peut être expliquée en constatant que, plus l'ouverture est grande, plus la probabilité de rencontrer des zones de vitesses du son différente est élevée.

Une solution pour réduire les interférences qui résultent d'une telle défocalisation consiste à comparer par corrélation les signaux échographiques reçus. La demande de brevet européen n° 0256481 décrit un appareil dans lequel, pour remédier aux inhomogénéités de la vitesse ultrasonore dans les milieux explorés et aux défauts d'image qui en résultent, un corrélateur prévu en parallèle sur les voies de réception permet de déterminer des valeurs de correction qui sont envoyées vers des lignes à retard prévues dans les voies d'émission pour modifier de façon spécifique les retards de focalisation à l'émission.

Le but de l'invention est de proposer un échographe de structure plus simple, ne faisant plus appel, pour l'évaluation des valeurs de correction des retards de focalisation, à des corrélateurs.

L'invention concerne à cet effet un appareil tel que défini dans le préambule et caractérisé en ce que lesdits moyens de détermination comprennent, en parallèle, (n-1) circuits de correction recevant chacun distinctement deux des n signaux échographiques focalisés successifs en vue de la détermination respective de chacune desdites (n-1) valeurs de correction, chacun de ces circuits et par exemple le i-ième circuit comprenant :
- un étage d'ouverture d'une fenêtre temporelle constituant la période pendant laquelle la i-ième valeur de correction correspondante est déterminée ;
- un étage de détermination, pendant ladite i-ième période, du déphasage entre les signaux échographiques focalisés de rang (i) et (i+1) reçus par ledit circuit de correction, ledit étage de détermination de déphasage comprenant lui-même en série :
- pour la détermination de la valeur absolue dudit déphasage, une porte ET recevant ladite fenêtre temporelle et les signaux de rang (i) et (i+1), un compteur pour la détermination de la durée totale de maintien de ladite porte à son niveau haut pendant la durée de la fenêtre temporelle, un diviseur par le nombre des périodes pendant lequel ce maintien est obtenu en sortie de ladite porte, et une mémoire ;
- pour la détermination du signe dudit déphasage, une porte ET, un compteur, un comparateur, et une mémoire, ladite porte ET recevant également ladite fenêtre temporelle, le signal de rang, ainsi que le signal de rang i mais retardé par un circuit à retard ;
lesdits (n-1) déphasages ainsi déterminés constituant les (n-1) valeurs de correction de retards à déterminer ou leur étant directement liés.

Les particularités de l'invention apparaîtront maintenant de façon plus détaillée dans la description qui suit et dans les dessins annexés, donnés à titre d'exemples non limitatifs et dans lesquels :
- la figure 1a montre un exemple de réalisation d'un échographe ultrasonore incorporant un étage de correction de focalisation selon l'invention, et la figure 1b le sous-ensemble de traitement et de visualisation de cet échographe ;
- la figure 2a montre de façon plus détaillée l'étage de correction de focalisation selon l'invention, la figure 2b l'un des circuits de correction dudit étage, et la figure 3 quelques signaux présents en divers points du circuit de la figure 2b.

L'échographe ultrasonore représenté sur la figure la comprend tout d'abord une sonde transductrice composée d'un réseau de m transducteurs ultrasonores 10a à 10m connectés à un aiguilleur analogique 15 qui permet de définir l'ouverture. L'autre extrémité de cet aiguilleur 15 est connectée d'une part à un étage d'émission 20 et d'autre part à un étage 300 de réception et traitement.

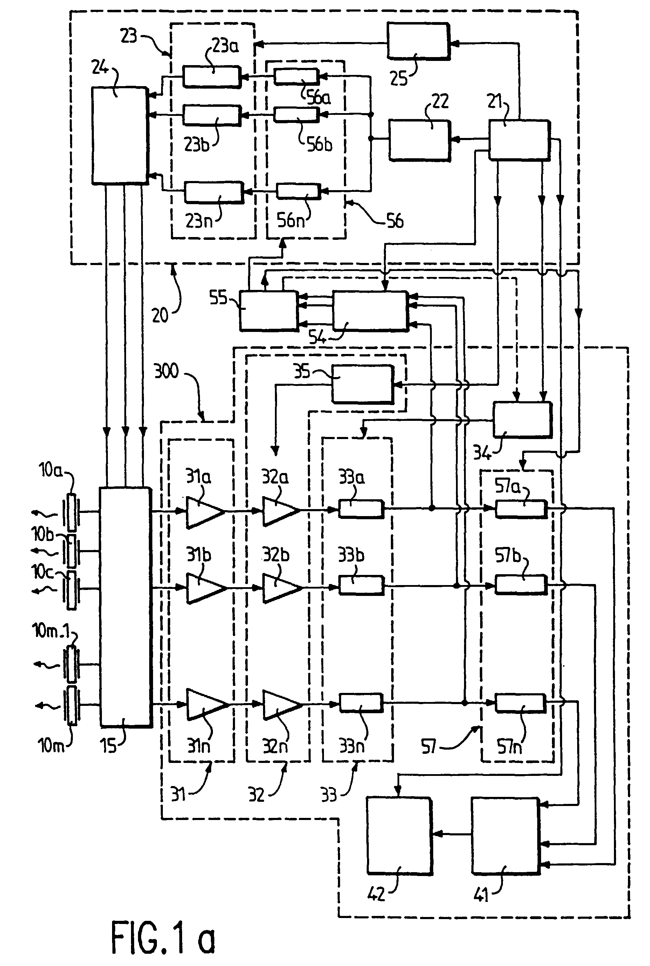

L'étage d'émission 20 comprend ici les éléments suivants :
(a) un circuit séquenceur 21 définissant la cadence des tirs ultrasonores, à une fréquence de récurrence de l'ordre de 3 à 5 kilohertz par exemple, et comprenant essentiellement, pour délivrer les différents signaux d'horloge nécessaires, un oscillateur et un diviseur de fréquence ;
(b) en sortie du circuit séquenceur 21, un circuit 22 d'émission des signaux électriques d'excitation des transducteurs, cette excitation étant commandée soit selon une loi temporelle appropriée pour permettre une focalisation des signaux ultrasonores, soit au contraire en phase, les différents retards de focalisation étant alors obtenus (c'est le cas représenté sur la figure 1a) à l'aide de n lignes à retard 23a à 23n placées en aval du circuit 22, respectivement dans les n voies d'émission associées aux n transducteurs utilisés pour l'émission (n inférieur à m) ;
(c) si la focalisation n'a pas été réalisée par le circuit 22 (comme indiqué en (b)), les n lignes à retard 23a à 23n, constituant un circuit de focalisation électronique 23 ;
(d) un circuit 24 d'activation de la haute tension, délivrant les impulsions hautes tension pour l'exécution de l'émission par les transducteurs.

Le circuit séquenceur 21 délivre non seulement les impulsions de synchronisation des tirs ultrasonores, mais aussi les signaux de commande d'un circuit 25 de contrôle de focalisation à l'émission. Ce circuit 25 contient en mémoire la séquence des lois de retards à l'émission pour chaque transducteur, cette séquence étant destinée à assurer la configuration des lignes à retard 23a à 23n du circuit de focalisation 23 selon une loi prédéfinie pour chaque tir.

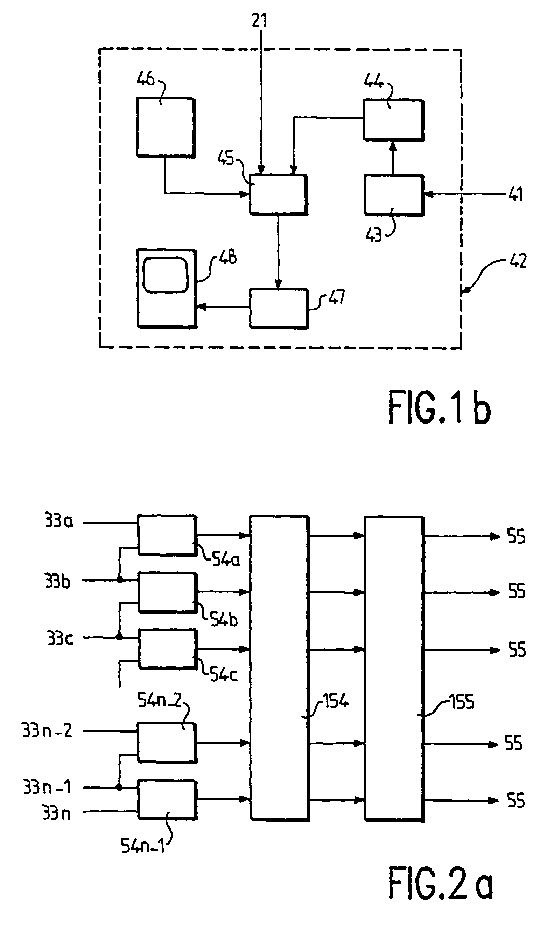

L'étage 300 de réception et traitement est composé de n voies de réception et traitement comprenant elles-mêmes, dans le cas présent, les éléments successifs suivants :
(a) des préamplificateurs 31a à 31n, l'ensemble des n préamplificateurs constituant un circuit de préamplification 31 qui reçoit les n signaux échographiques correspondant à l'ouverture du réseau de transducteurs ;
(b) un circuit de compensation de gain en fonction du temps 32, comprenant essentiellement n amplificateurs 32a à 32n à gain variable en fonction du temps, contrôlés par un circuit de commande 35 qui reçoit lui-même des impulsions de synchronisation en provenance du circuit séquenceur 21 :
(c) des lignes à retard 33a à 33n, l'ensemble de ces lignes à retard constituant un circuit 33 de focalisation à la réception (focalisation dynamique) relié à une mémoire 34 commandée par le circuit séquenceur 21 et contenant en mémoire, pour chaque voie, l'ensemble des lois de retard pour chaque zone de focalisation et pour chaque ligne de l'image ;
(d) un sommateur 41, qui reçoit les sorties des n voies de réception et traitement ainsi constituées ;
(e) pour l'obtention d'images de plans de coupe du milieu exploré, un sous-ensemble de traitement et de visualisation 42, représenté sur la figure 1b et comprenant essentiellement :
   - un détecteur d'enveloppe 43 recevant la sortie du sommateur 41 et suivi d'un convertisseur analogique-numérique 44 ;
   - un convertisseur de balayage 45 recevant d'une part la sortie du convertisseur analogique-numérique 44, d'autre part la sortie d'une mémoire 46 définissant les positions des lignes explorées par rapport à la sonde, et également des signaux de synchronisation fournis là encore par le circuit séquenceur 21 ;
   - une mémoire d'image 47 servant de mémoire-tampon pour l'écriture des signaux de sortie du convertisseur de balayage 45, et dont les signaux de sortie sont eux-mêmes, après lecture de cette mémoire, affichés sur un écran de visualisation 48.

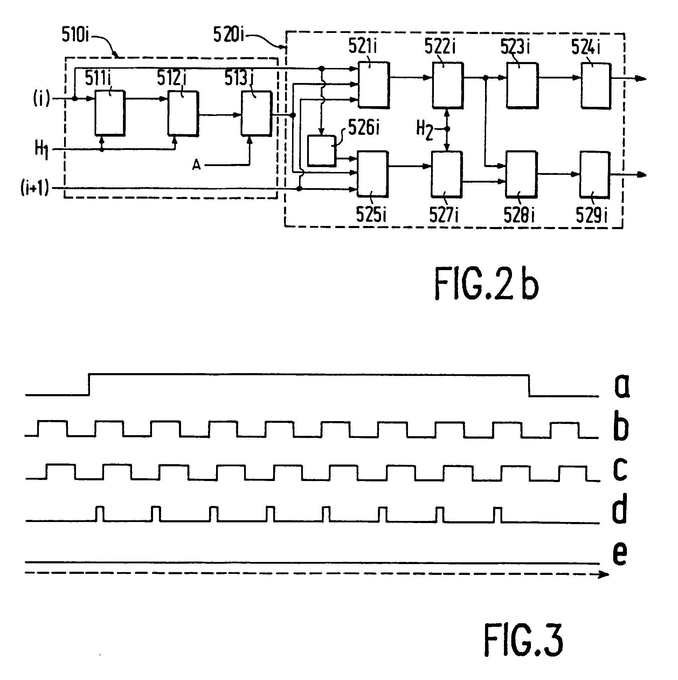

Conformément à l'invention, l'étage 300 comprend également, en sortie des n voies de réception et traitement et en parallèle sur elles, un étage 54 de correction de focalisation représenté plus en détail sur la figure 2a. Comme le montre cette figure, l'étage 54 comprend, en parallèle, (n-1) circuits de correction 54a à 54n-1, recevant chacun deux des n signaux échographiques focalisés et représentés eux-mêmes plus en détail sur la figure 2b qui montre l'un d'eux, par exemple le circuit de correction 54i.

Ce circuit 54i, dans l'exemple de réalisation représenté, comprend tout d'abord un étage 510i d'ouverture d'une fenêtre temporelle, qui reçoit les signaux échographiques de rang (i) et (i+1) et est destiné à engendrer un signal représenté en (a) sur la figure 3 (cette figure 3 montre les signaux présents en divers points du circuit 54i de la figure 2b). L'étage 510i comprend lui-même successivement :
- deux bascules en série 511i et 512i destinées à filtrer le signal échographique de rang (i) pour supprimer les flancs parasites éventuels de ce signal (la bascule 511i reçoit ledit signal échographique ainsi que, en provenance du circuit séquenceur 21, un signal d'horloge H_{1,} ici à 18 mégahertz, et la bascule 512i reçoit la sortie de la bascule 511i ainsi que ledit signal d'horloge) ;
- un premier compteur 513i recevant le signal filtré présent sur la sortie de la bascule 512i, et destiné à compter le nombre d'impulsions du signal échographique ainsi filtré après ouverture de la fenêtre temporelle de la figure 3a (cette ouverture est commandée par un signal A provenant du circuit séquenceur 21), en vue de la fermeture de ladite fenêtre après un nombre déterminé de périodes de ce signal échographique (de préférence 8, ou 16).

Les signaux échographiques de rang (i) et (i+1) sont représentés sur la figure 3, en (b) et (c). On précisera ici que ces signaux échographiques sont obtenus après la conversion analogique-numérique sur 1 bit des signaux échographiques analogiques fournis par les voies de traitement à la réception, ce qui explique leur aspect rectangulaire.

Le circuit 54i représenté comprend d'autre part un étage 520i de détermination de déphasage, comprenant lui-même un circuit de détermination de la valeur absolue du déphasage entre les signaux échographiques de rang (i) et (i+1) et un circuit de détermination du signe de ce déphasage.

Le circuit de détermination de valeur absolue comprend d'abord une porte ET 521i, qui reçoit les deux signaux de rang (i) et (i+1) ainsi que le signal de fenêtre temporelle et délivre, tant que ce dernier est au niveau correspondant à l'ouverture de cette fenêtre (ici niveau haut), un signal numérique de largeur proportionnelle à la valeur absolue du déphasage entre les signaux de rang (i) et (i+1). Le signal de sortie de cette porte ET 521i est représenté sur la figure 3d. Cette porte est suivie d'un deuxième compteur 522i. Ce compteur 522i, qui reçoit du circuit séquenceur 21 un signal d'horloge H₂ à la fréquence d'échantillonnage des signaux de rang i (i+1), ici 40 mégahertz, permet la détermination de la durée totale pendant laquelle la sortie de la porte ET 521i est au niveau haut, c'est-à-dire de la somme des durées correspondant, sur la figure 3d, au niveau haut des impulsions représentées. Le compteur 522i est lui-même suivi d'un diviseur 523i (ici par 8, ou par 16). Le rapport de division du diviseur 523i est, en fait, identique au nombre déterminé de périodes du signal échographique filtré qui sont présentes à l'intérieur du signal de fenêtre temporelle engendré par l'étage 510i, et cette division revient à déterminer la durée moyenne d'une des impulsions de la figure 3d. Une première mémoire 524i permet finalement de stocker le signal de sortie du diviseur 523i, correspondant à la valeur absolue du déphasage à déterminer.

Le circuit de détermination du signe de ce déphasage comprend de façon similaire une porte ET 525i, qui reçoit également les deux signaux de rang (i) et (i+1) - dont l'un retardé d'une période d'horloge d'échantillonnage par un circuit à retard 526i - et le signal de fenêtre temporelle, et dont le signal de sortie est représenté sur la figure 3e. Cette porte ET 525i est suivie d'un troisième compteur 527i, lui-même suivi d'un comparateur 528i. Comme précédemment, le compteur 527i, qui reçoit également le signal d'horloge H_{2,} détermine la durée totale pendant laquelle la sortie de la porte ET 525i est au niveau haut. Du fait du retard apporté par le circuit 526i, cette durée est différente de celle déterminée par le compteur 522i. En comparant alors ces deux durées et en tenant compte aussi des positions relatives initiales (en l'absence dudit retard introduit par le circuit 526i) des signaux de rang i et (i+1), on en déduit le signe du déphasage. Comme dans le cas du circuit de détermination de valeur absolue, le comparateur 528i est suivi d'une deuxième mémoire 529i permettant finalement de stocker le signal de sortie de ce comparateur, qui correspond au signe du déphasage.

Chaque circuit de correction tel que 54i permet donc de déterminer le retard entre deux des signaux échographiques (comme ces signaux sont focalisés de façon dynamique dès le premier tir, cette focalisation est simplement, lors de ce premier tir, effectuée comme s'il n'existait pas d'inhomogénéités dans le milieu exploré). L'ensemble des (n-1) valeurs de retards ainsi délivrées par les (n-1) circuits de correction 54a à 54n-1 est alors traité, comme indiqué sur la figure 2a, dans un circuit de recalage 154, qui procède au recalage de ces valeurs par rapport à une référence commune (par exemple par rapport à la première voie, mais ce pourrait être par rapport à l'une quelconque d'entre elles). Le circuit de recalage 154 est suivi ici d'un circuit 155 de régression linéaire sur les (n-1) valeurs recalées, afin d'en supprimer la tendance linéaire due à l'éventuelle présence de cibles situées hors de l'axe de focalisation (l'ordre dans lequel sont effectués ce recalage et cette suppression de tendance linéaire n'est donné ici qu'à titre d'exemple et peut être modifié).

Dans l'exemple de réalisation ici décrit, ce sont donc les (n-1) sorties du circuit 155 qui constituent les sorties de l'étage 54 de correction de focalisation. Les retards ainsi estimés sont stockés dans un circuit de mémorisation 55 puis introduits, avant déclenchement du tir suivant, dans les voies d'émission à l'aide de lignes à retards 56a à 56n constituant un circuit 56 de correction à l'émission, placé par exemple juste en amont du circuit de focalisation électronique 23. Une nouvelle émission peut alors être effectuée, qui tient compte, dans la focalisation à l'émission, des corrections ainsi effectuées sur les retards propres à chaque voie d'émission. A la réception des signaux échographiques correspondant à ce nouveau tir, les retards entre ces signaux sont à nouveau déterminés comme précédemment, puis réintroduits juste avant le tir suivant dans chaque voie d'émission, et ainsi de suite. On réalise donc, de cette façon, une correction itérative des inhomogénéités de vitesse ultrasonore dans les milieux explorés.

Bien entendu, la présente invention n'est pas limitée aux exemples de réalisation décrits, à partir desquels des variantes peuvent être proposées sans pour cela sortir du cadre de l'invention. Par exemple, il est tout à fait possible d'interrompre le processus de correction itérative ainsi décrit lorsqu'on estime que ladite correction est efficace et suffisante. Cette interruption peut survenir par exemple soit après un nombre de tirs prédéterminé, soit à l'aide d'un critère d'interruption. On peut, par exemple, réaliser l'interruption lorsque l'énergie de la ligne échographique atteint un seuil prédéfini. On peut considérer en effet que cette énergie est maximale lorsque la focalisation est correcte à l'émission et à la réception. Un circuit de commande d'interruption, non représenté ici mais mis en place par exemple en amont de l'étage de correction 54, est alors prévu pour mettre en oeuvre cette variante. Par ailleurs, il faut bien considérer que la correction itérative selon l'invention, par rebouclages successifs d'informations de correction, est obtenue aussi bien lorsque les voies d'émission et/ou de réception sont numériques que lorsqu'elles sont analogiques, un convertisseur analogique-numérique étant alors inséré dans chacune de ces voies, en série, par exemple en sortie du circuit de compensation de gain en fonction du temps 32. Cette variante n'est pas représentée, sa réalisation étant facilement déduite de la figure 1a.

On remarquera aussi que les retards estimés et stockés dans le circuit de mémorisation 55 peuvent être réintroduit lors du tir suivant non seulement dans les voies d'émission mais également dans les voies de réception et traitement, ou bien, aussi, réintroduits dans les voies de réception et traitement immédiatement, tant que le tir en cours n'est pas achevé, par l'intermédiaire d'un circuit 57 de correction à la réception. Ce circuit 57 inclus dans l'étage 300 est ici constitué de lignes à retards 57a à 57n, prévues en série dans chacune des voies de réception et traitement respectivement, une connexion de sortie supplémentaire reliant le circuit 55 et ce circuit 57.

On notera enfin que les signaux A, H_{1,} H₂ sont bien entendu fournis à chacun des (n-1) circuits de correction 54a à 54n-1 de la figure 2a.

## Revendications

1. Appareil d'examen de milieux par échographie ultrasonore, comprenant un réseau de m éléments transducteurs ultrasonores (10a,..., 10m) associé à un étage (20) d'émission de signaux ultrasonores vers le milieu à explorer et à un étage (300) de réception et traitement des signaux échographiques renvoyés par le milieu exploré vers lesdits éléments transducteurs, lesdits étages d'émission et de réception et traitement comprenant respectivement des moyens de focalisation par application de retards appropriés dans les n voies d'émission et dans les n voies de réception qui sont associées, parmi lesdits m éléments, aux n éléments transducteurs constituant l'ouverture ultrasonore, l'étage de réception et traitement comprenant en outre :
(a) des moyens de détermination de (n-1) valeurs de correction des retards de focalisation, associés auxdites n voies de réception ;
(b) des moyens de correction, en fonction des (n-1) valeurs ainsi déterminées, des retards de focalisaton à l'émission et/ou à la réception ;
caractérisé en ce que lesdits moyens de détermination comprennent, en parallèle, (n-1) circuits de correction (54a,..., 54n-1) recevant chacun distinctement deux des n signaux échographiques focalisés successifs en vue de la détermination respective de chacune desdites (n-1) valeurs de correction, chacun de ces circuits et par exemple le i-ième circuit comprenant :
- un étage (510i) d'ouverture d'une fenêtre temporelle constituant la période pendant laquelle la i-ième valeur de correction correspondante est déterminée ;
- un étage (520i) de détermination, pendant ladite i-ième période, du déphasage entre les signaux échographiques focalisés de rang (i) et (i+1) reçus par ledit circuit de correction, ledit étage de détermination de déphasage comprenant lui-même en série :
- pour la détermination de la valeur absolue dudit déphasage, une porte ET (521i) recevant ladite fenêtre temporelle et les signaux de rang (i) et (i+1), un compteur (522i) pour la détermination de la durée totale de maintien de ladite porte à son niveau haut pendant la durée de la fenêtre temporelle, un diviseur (523i) par le nombre des périodes pendant lequel ce maintien est obtenu en sortie de ladite porte, et une mémoire (524i) ;
- pour la détermination du signe dudit déphasage, une porte ET (525i), un compteur (527i), un comparateur (528i), et une mémoire (529i), ladite porte ET recevant également ladite fenêtre temporelle, le signal de rang (i+1), ainsi que le signal de rang i mais retardé par un circuit à retard ;
lesdits (n-1) déphasages ainsi déterminés constituant les (n-1) valeurs de correction de retards à déterminer ou leur étant directement liés.

2. Appareil selon la revendication 1, caractérisé en ce que ledit étage (510i) d'ouverture d'une fenêtre temporelle comprend lui-même :
- pour le filtrage dudit signal échographique de rang (i), deux bascules en série (511i, 512i) recevant également un signal d'horloge H₁ ;
- pour la définition de la i-ième fenêtre temporelle, un compteur (513i) du nombre d'impulsions dudit signal échographique filtré destinées à être contenues dans ladite fenêtre, ledit compteur recevant d'une part le signal ainsi filtré et d'autre part un signal d'ouverture de ladite fenêtre.

3. Appareil selon l'une des revendications 1 et 2, caractérisé en ce que lesdites (n-1) valeurs de correction sont fournies auxdits moyens de correction par l'intermédiaire d'un circuit de recalage (154) et d'un circuit (155) de régression linéaire sur les (n-1) valeurs ainsi recalées.

## Claims

1. An apparatus for examining media by ultrasonic echography, comprising an array of m ultrasonic transducer elements (10a,...,10m) associated with a stage (20) for the transmission of ultrasonic signals to the medium to be examined and with a stage (300) for receiving and processing echographic signals returned to said transducer elements by the medium being examined, said transmission stage and receiving and processing stage comprising means for focusing by the provision of suitable delays in the n transmission channels and in the n receiving channels associated with the n transducer elements, among said m elements, forming the ultrasonic aperture, the receiving and processing stage also comprising:
**(a)** associated with the n receiving channels, means for determining (n-1) correction values for the focusing delays;
**(b)** means for the correction of focusing delays, as a function of the (n-1) values thus determined, in the transmission mode and/or the receiving mode;
characterized in that said means for determining comprise, in parallel, (n-1) correction circuits (54a,...54n-1) each of which separately receives two of the n successive focused echographic signals for respective determination of each of said (n-1) correction values, each of said circuits, for example the i^{th} circuit, comprising:
- a stage (510i) for opening a time window defining the period during which the i^{th} corresponding correction value is determined;
- a stage (520i) for determining, during said i^{th} period, the phase shift between the focused echographic signals of the ranks (i) and (i+1) received by said correction circuit, said phase-shift determining stage itself comprising a series connection of:
- for determining the absolute value of said phase shift and AND-gate (521i) which receives said time window and the signals of ranks (i) and (i+1), a counter (522i) for determining the total period of time during which said gate is held at its high level during the time window, a divider (523i) for dividing by the number of periods during which the output of said gate is held at said level, and a memory (524i);
- for determining the sign of said phase shift an AND-gate (525i), a counter (527i), a comparator (528i), and a memory (529i), said AND-gate also receiving said time window, the signal of rank (i+1), as well as the signal of rank i but delayed by a delay circuit;
said (n-1) phase shifts thus determined constituting the (n-1) delay correction values to be determined or being directly linked thereto.

2. An apparatus as claimed in Claim 1, characterized in that said stage (510i) for opening a time window itself comprises:
- for filtering said echographic signal of the rank (i) two flip-flops (511i, 512i) in series which also receive a clock signal H₁;
- for defining the i^{th} time window a counter (513i) for counting the number of pulses of said filtered echographic signal, which pulses are to be accommodated within said window, said counter receiving both the signal thus filtered and a signal for opening said window.

3. An apparatus as claimed in one of the Claims I and 2, characterized in that said (n-1) correction values are applied to said correction means by means of a rephasing circuit (154) and a circuit (155) for linear regression the (n-1) values thus rephased.

## Patentansprüche

1. Gerät zur Untersuchung von Umgebungen durch Ultraschall-Echographie mit einem Array von m Ultraschallwandler-Elementen (10a,...,10m), die zu einer Stufe (20) zur Aussendung von Ultraschallsignalen in Richtung einer zu untersuchenden Umgebung und einer Stufe (300) zum Empfang und zur Verarbeitung von Echographiesignalen, die von der untersuchten Umgebung in Richtung der genannten Wandlerelemente zurückgesendet werden, gehören, wobei die genannten Stufen zur Aussendung sowie zum Empfang und zur Verarbeitung Mittel zur Fokussierung durch Anwendung geeigneter Verzögerungen in den n Sende- bzw. den n Empfangskanälen umfassen, die unter den genannten m Elementen zu den n Wandlerelementen gehören, die die Ultraschallöffnung bilden, wobei die Stufe zum Empfang und zur Verarbeitung außerdem folgendes umfaßt:
(a) Mittel zur Bestimmung von (n-1) Korrekturwerten für die Fokussierungsverzögerungen, die zu den genannten n Empfangskanälen gehören,
(b) Mittel zur Korrektur der Fokussierungsverzögerungen beim Senden und/oder beim Empfang in Abhängigkeit von den (n-1) so bestimmten Werten,
dadurch gekennzeichnet, daß die genannten Bestimmungsmittel (n-1) parallel geschaltete Korrekturschaltungen (54a,...,54n-1) umfassen, von denen jede unterschiedlich zwei der n aufeinanderfolgenden fokussierten Echographiesignale empfangt, um jeweils jeden der genannten (n-1) Korrekturwerte zu bestimmen, wobei jede dieser Schaltungen, beispielsweise die i-te, folgendes umfaßt:
- eine Stufe (510i) zur Öffnung eines Zeitfensters, das die Periode bildet, während der der i-te entsprechende Korrekturwert bestimmt wird,
- eine Stufe (520i) zur Bestimmung der Phasenabweichung zwischen den von der genannten Korrekturschaltung empfangenen, fokussierten Echographiesignalen mit Rang (i) und (i+1) während der genannten i-ten Periode, wobei die genannte Stufe zur Bestimmung der Phasenabweichung selbst in Reihe geschaltet folgendes umfaßt:
- zur Bestimmung des Absolutwertes der genannten Phasenabweichung ein UND-Gatter (521i), das das genannte Zeitfenster und die Signale mit Rang (i) und (i+1) empfängt, einen Zähler (522i) zur Bestimmung der Gesamtdauer der Aufrechterhaltung des hohen Niveaus des UND-Gatters während der Dauer des Zeitfensters, einen Teiler (523i), der durch die Anzahl der Perioden teilt, während der diese Aufrechterhaltung am Ausgang des genannten Gatters empfangen wird, und einen Speicher (524i),
- zur Bestimmung des Vorzeichens der genannten Phasenabweichung, ein UND-Gatter (525i), einen Zähler (527i), einen Vergleicher (528i) und einen Speicher (529i), wobei das genannte UND-Gatter ebenfalls das genannte Zeitfenster, das Signal mit Rang (i+1) sowie das Signal mit Rang i, jedoch durch eine Verzögerungsschaltung verzögert, empfängt; wobei die genannten so bestimmten (n-1) Phasenabweichungen die (n-1) zu bestimmenden Korrekturwerte für Verzögerungen darstellen oder mit diesen direkt verbunden sind.

2. Gerät nach Anspruch 1, dadurch gekennzeichnet, daß die genannte Stufe (510i) zur Öffnung eines Zeitfensters selbst folgendes umfaßt:
- für die Filterung des genannten Echographiesignals mit Rang (i), zwei in Reihe geschaltete Kippschaltungen (511i, 512i), die auch ein Taktsignal H₁ empfangen,
- für die Definition des i-ten Zeitfensters, einen Zähler (513i) für die Anzahl der Impulse des genannten gefilterten Echographiesignals, die im genannten Fenster enthalten sein sollen, wobei der genannte Zähler erstens das so gefilterte Signal und zweitens ein Öffnungssignal für das genannte Fenster empfängt.

3. Gerät nach einem der Ansprüche 1 und 2, dadurch gekennzeichnet, daß die genannten (n-1) Korrekturwerte den genannten Korrekturmitteln über eine Glättungsschaltung (154) und eine Schaltung (155) zur linearen Regression über die (n-1) so geglätteten Werte zugeführt werden.
